(19) Europäisches Patentamt
European Patent Office
Office européen des brevets

(11) **EP 0 632 576 B1**

(12) **EUROPÄISCHE PATENTSCHRIFT**

(45) Veröffentlichungstag und Bekanntmachung des Hinweises auf die Patenterteilung:
**16.09.1998 Patentblatt 1998/38**

(51) Int Cl.$^6$: **H03C 3/00**

(21) Anmeldenummer: **94109162.1**

(22) Anmeldetag: **15.06.1994**

(54) **Verfahren zur Frequenzmodulation**

Frequency modulation method

Procédé de modulation de fréquence

(84) Benannte Vertragsstaaten:
**AT CH DE ES FR GB IT LI NL**

(30) Priorität: **24.06.1993 DE 4320997**

(43) Veröffentlichungstag der Anmeldung:
**04.01.1995 Patentblatt 1995/01**

(73) Patentinhaber: **ROBERT BOSCH GMBH**
**70442 Stuttgart (DE)**

(72) Erfinder: **Göckler, Heinz, Dr.**
**D-71522 Backnang (DE)**

(56) Entgegenhaltungen:
**EP-A- 0 419 680           EP-A- 0 508 661**
**DE-A- 4 026 476           US-A- 5 111 163**

- **PATENT ABSTRACTS OF JAPAN vol. 11, no. 249 (E-532) 13. August 1987 & JP-A-62 062 603 (MATSUSHITA ELECTRIC IND CO)**

**Beschreibung**

Die Erfindung bezieht sich auf ein Verfahren zur FM-Modulation gemäß Oberbegriff des Patentanspruches 1. Solche Verfahren sind bekannt, beispielsweise aus der Europäischen Offenlegungsschrift 508 661, die einen FM-Modulator beschreibt, der zur Erzeugung eines frequenzmodulierten Signales digitale Mittel in beschränkter Form benutzt, z.B. einen rückgekoppelten Phasenakkumulator zur Erzeugung eines digitalen frequenzmodulierten Signales und einen Trägeroszillator, welcher aus einer Tabelle Sinus- oder Cosinuswerte der Trägerschwingung ausliest. Dieser bekannte FM-Modulator gestattet zwar die beliebige Einstellung von Frequenzhub und Mittenfrequenz und zwar unabhängig voneinander, weist aber eine Reihe von Nachteilen auf wie z.B. Drift- und Alterungs- Probleme, nichtlineare Verzerrungen, das Erfordernis eines Abgleiches usw., welche alle daher rühren, daß der wesentliche Schaltungsaufwand dieses Modulators auf analoge Weise realisiert ist.

Der Anmeldung EP 94109164, die als EP-A-0 631 378 am 28.12.94 veröffentlichtist, lag die Aufgabe zugrunde, ein Verfahren zur FM-Modulation eines digitalen NF-Signals der Eingangs genannten Art anzugeben, welches die genannten Nachteile nicht aufweist.

Durch die Volldigitale Realisierung dieses FM-Modulators ergeben sich die Vorteile,

daß Drift- und Alterungsprobleme entfallen, daß kein Abgleich erforderlich ist, wodurch Personal- und zeitintensive Aufwände entfallen,

daß eine volle Integrationsfähigkeit als VLSI- bzw. ASIC-Baustein möglich ist,

daß nichtlineare Verzerrungen minimal sind,

daß eine Anwendung sowohl in volldigitaler als auch in analoger bzw. halbanaloger Umgebung möglich ist, letztere durch eine Ausstattung am Ein- oder Ausgang mit Analog-/Digital- bzw. Digital-/Analog-Umsetzung.

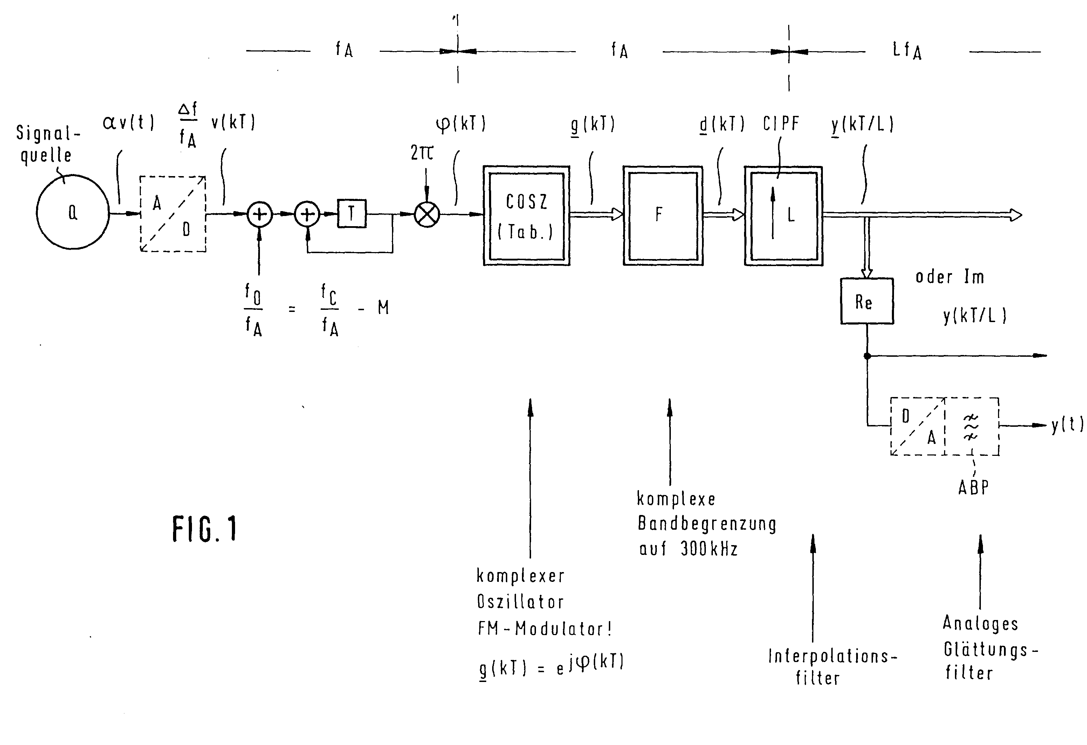

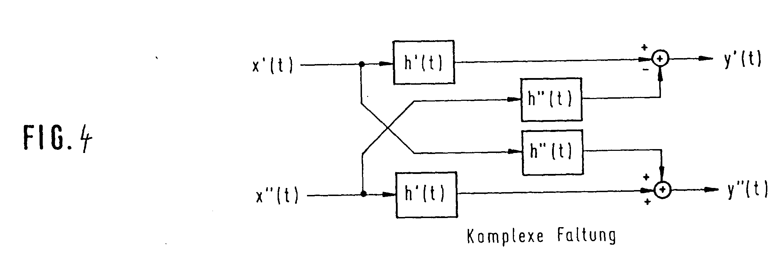

Es folgt die Beschreibung dieser obengenannten Anmeldung EP94109164 anhand der Figuren 1, 2a bis 2e und 4. Das Prinzip des Verfahrens ist anhand der Figur 1 erläuterbar, die das Blockschaltbild eines FM-Modulators, volldigital realisiert, zeigt. Die Figuren 2a bis 2e geben Spektren und Übertragungsfunktionen an einzelnen Punkten bzw. einzelner Bausteine der Figur 1 wieder. Die Figur 4 veranschaulicht die komplexe Faltung.

Die Signalquelle Q liefert ein analoges bandbegrenztes Signal $\alpha \cdot v(t)$, welches durch einen Analog-Digital-Umsetzer anschließend digitalisiert wird, oder unmittelbar ein digitales Signal $v(kT) \cdot f/f_A$, wobei $T = 1/f_A$ das Abtastintervall ist, das nachfolgend einen Träger der Frequenz $f_C$ bzw. der FM-Mittenfrequenz $f_0$ in der Frequenz moduliert mit dem Frequenzhub f. Dem digitalen modulierenden Signal $v(kT)$ mit $k = 0,1,...$ wird zunächst eine Konstante $f_0/f_A$ hinzu addiert, mit der die ausgangsseitig erwünschte Kanalmittenfrequenz $f_C = M \cdot f_A + f_0$ festgelegt wird, wobei M eine ganze Zahl ist. Damit ergibt sich die auf die Abtastfrequenz normierte Momentanfrequenz des FM-Signals in der Zwischenfrequenzlage um $f_0$ zu

$$\frac{f(k)}{f_A} = \frac{f_0}{f_A} + \frac{\Delta f}{f_A} \cdot v(k) \qquad (1),$$

wobei der Term $k \cdot T$ abkürzend durch k, den laufenden Zeit-bzw. Abtastindex, ersetzt wurde. Die Größe $\Delta f$ ist der Frequenzhub, der unabhängig von $f_0$ wählbar ist und der angibt, um wieviel die Momentanfrequenz des modulierenden FM-Signals maximal von der Schwerpunktfrequenz $f_0$ (das ist die Frequenz des unmodulierten Signals) abweichen kann, wenn ohne Einschränkung der Allgemeinheit

$$\text{max.} \{ v(k)\} \equiv 1$$

gesetzt wird.

Aus (1) folgt die momentane Phase des FM-Signals durch Integration, was im Digitalen durch den idealen Integrator nämlich durch einen rückgekoppelten Akkumulator, realisiert wird mit nachfolgender Multiplikation mit $2\pi$:

$$\varphi(kT) = 2\pi \sum_{\varkappa=0}^{k} [f_0/f_A + v(k) \cdot \triangle f/f_A]$$

$$= 2\pi \, kf_0/f_A + 2\pi \triangle f/f_A \sum_{\varkappa=0}^{k} v(\varkappa)$$

$$= \omega_0 \, kT \quad + \triangle \Omega \, T \sum_{\varkappa=0}^{k} v(\varkappa) \tag{2}$$

Anschließend erfolgt die komplexe Trägererzeugung und -Umsetzung, wobei aus einer Tabelle das komplexwertige FM-Signal

$$\underline{g}(k) = e^{j\varphi(k)} = g_r(k) + jg_i(k)$$

$$= \cos[\varphi(k)] + j\sin[\varphi(k)] \tag{3}$$

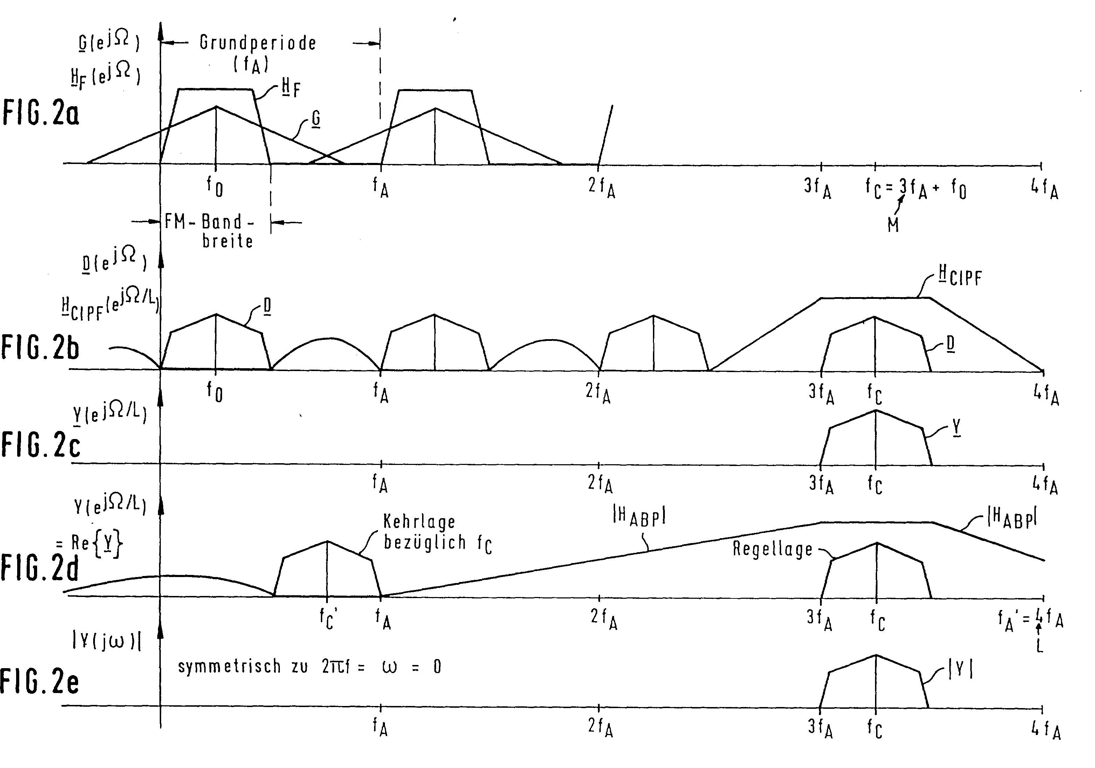

ausgelesen wird. Die komplexwertigen Signale sind in Figur 1 und Figur 2 durch Unterstreichung und in Figur 1 ihre Signalpfade durch Doppel-Striche bzw. Doppel Pfeile und die Bausteine mit komplexwertigen Koeffizienten wie Filter, Tabellen usw. mit doppelter Berandung gekennzeichnet. $j = \sqrt{-1}$, zuerst in Gleichung 3 verwendet, ist die Imaginäreinheit, die rechnerisch nur implizit zu berücksichtigen ist. Ein komplexwertiges Signal stellt ein Signal dar, das aus zwei Komponenten, nämlich dem Real- und dem Imaginärteil zusammengesetzt ist. Das FM-Signal $\underline{g}(k)$ ist idealerweise nicht bandbegrenzt, weshalb es durch ein Filter F mit komplexen Koeffizienten so bandzubegrenzen ist, daß die Systemanforderungen bezüglich Nachbarkanalstörungen eingehalten werden (bei UKW Bandbreite 300 kHz): Das Ergebnis am Filterausgang $\underline{d}(k)$. Danach folgt ein Interpolations-Filter CIPF mit komplexen Koeffizienten, welches die Abtastfrequenz $f_A$ um den erforderlichen Faktor L erhöht, so daß am Filterausgang nur das gewünschte FM-Siganl y (kT/L) um

$$f_C/f_A = M + f_0/f_A \tag{4}$$

erscheint im Bereich $[0, L \cdot f_A]$. Das bedeutet, daß das komplexe Interpolations-Filter CIPF um $f_C$ einen Durchlaßbereich aufweisen und bei bezüglich $f_A$ periodischen Spektralanteilen sperren muß.

Wird nun im System nur ein reelles FM-Signal benötigt, so wird lediglich der Realteil oder der Imaginärteil weiter verwendet. Gegebenenfalls kann eine Digital-Analog-Umsetzung erforderlich sein, der dann üblicherweise ein analoges Glättungs-Filter ABP (meistens Tiefpass, aber auch Bandpass) folgt.

Die Funktionsweise des beschriebenen FM-Modulators wird nun im Frequenzbereich spektralmäßig erläutert. In den Figuren 2a bis 2e sind die Spektren jeweils mit den entsprechenden Großbuchstaben bezeichnet und beispielhaft Werte für M = 3 und L = 4 angesetzt.

Durch die Fouriertransformation sind Übertragungsfunktion und Impulsantwort bzw. Frequenz- und Zeitbereich miteinander verbunden:

$$\underline{G}(e^{j\Omega}) \bullet\!\!-\!\!-\!\!\circ \underline{g}(kT) \tag{5}$$

Am Ausgang des komplexen Oszillators COSZ entsteht das Spektrum $\underline{G}(e^{j\Omega})$, siehe Figur 2a, das mit dem Filter F auf die zulässige Bandbreite begrenzt wird zu $\underline{D}(e^{j\Omega})$, siehe Figur 2b. Falls die Mittenfrequenz $f_0 = 0$ ist, sind Filterfunktion und Spektrum bezüglich f = 0 bzw. bezüglich $f_A$ nichtsymmetrisch (Eigenschaften komplexwertiger Signale). Das Interpolations Filter CIPF selektiert den gewünschten Spektralanteil um $f_C$, was möglich ist, da es auf die erhöhte Abtastfrequenz $L \cdot f_A = 4f_A$ bezogen ist (siehe $\underline{D}$ am Eingang von CIPF, Figur 2b, und $\underline{Y}$ am Ausgang von CIPF, Figur 2c). Wird nur der Real- oder Imaginärteil weiter verwendet, so ergibt sich das Spektrum Y gemäß Figur 2d. Dieses Spektrum Y ist mit den gezeichneten Spektren symmetrisch sowohl bezüglich f = 0 als auch $f_A'/2 = 2f_A$, da es sich hier im Unterschied zur Figur 2a bis 2c um ein reelles Signal handelt. Dasselbe gilt auch für das analoge Signal y(t) beziehungsweise für sein Spektrum IYI nach einer Digital-Analog-Umsetzung DAU mit nachfolgendem Glättungs-Filter ABP, siehe Figur 2e.

Wie aus den bisherigen Ausführungen und auch aus Figur 2a ersichtlich ist die Bandbreite des FM-Signals $\underline{g}$(k) und auch des bandbegrenzten FM-Signals $\underline{d}$(k) deutlich größer als die des modulierenden Signals v(k), beispielsweise bei UKW-Stereo 300 kHz zu 60 kHz.

Daher kann das modulierende Digital-Signal v(kT) auch mit niedrigerer Abtastfrequenz $f_A/P$ angeliefert werden mit

$$v' = v(kPT) \tag{6},$$

wobei P aus Aufwandsgründen, aber nicht zwingend, ganzzahlig gewählt werden sollte.

In diesem Fall ist an beliebiger Stelle zwischen Quelle Q bzw. nach dem Analog-Digital-Umsetzer ADU und dem komplexen Oszillator COSZ die Abtastfrequenz mittels eines Interpolations-Filters oder durch eine Kaskade von mehreren um den Faktor P zu erhöhen.

Die Multiplikation mit $2\pi$ vor dem komplexen Oszillator COSZ gemäß Figur 1 kann entfallen, wenn die Adressen für die COSZ-Tabelle entsprechend normiert werden: Adressraum [0,1] Modulo 1 statt [0,$2\pi$] Modulo $2\pi$.

Die Tabelle des komplexen Oszillators COSZ kann in folgenden Varianten aufgebaut sein:

1. Zwei Tabellen gleichen Inhalts werden mit unterschiedlichen Adressen angesteuert, wobei die Adressendifferenz $\Delta\varphi = \pi/2$ ist, und gleichzeitig parallel ausgelesen.

2. Es gibt eine gemeinsame Tabelle für Real- und Imaginärteil; diese Tabelle wird für Real- und Imaginärteil sequentiell angesteuert und ausgelesen.

3. Es gibt eine Tabelle für Realteil und eine Tabelle für Imaginärteil, beide sind so angeordnet, daß für eine Adresse der Realteil aus der einen und der Imaginärteil aus der anderen Tabelle gleichzeitig und parallel geliefert werden.

Die Abtastwerte der komplexen Schwingung gemäß Gl. (3) lassen sich aber auch jeweils aktuell berechnen, z.B. mit Hilfe ausreichend genauer Reihenentwicklungen.

Die Filter mit komplexen Koeffizienten lassen sich im allgemeinsten Fall mit 4 Teilfiltern mit jeweils reellen und paarweise gleichen Koeffizienten realisieren, siehe Figur 4, wodurch der Aufwand ebenfalls erheblich gesenkt wird. Interpolations-Filter, deren Ausgangs-Abtast-Frequenz für verfügbare Bausteine sehr hoch oder zu hoch ist so daß die Realisierung Schwierigkeiten bereitet oder überhaupt nicht möglich ist, lassen sich als sogenannte Polyphasenfilter Netzwerke realisieren, siehe hierzu

Deutsches Patent 40 26 476.9.

Die komplexen Filter F und CIPF können zu einem einzigen komplexwertigen Filter zusammengefaßt werden, was ebenfalls eine Aufwandsverminderung sein kann.

Aufgabe der vorliegenden Anmeldung war es, das Verfahren gemäß der oben genannten Anmeldung dahingehend zu verbessern, daß es bei vermindertem Aufwand dieselben Ergebnisse liefert.

Die Lösung erfolgt durch die Merkmale des Anspruches 1. Vorteilhaft Ausgestaltungen ergeben sich durch die Unteransprüche.

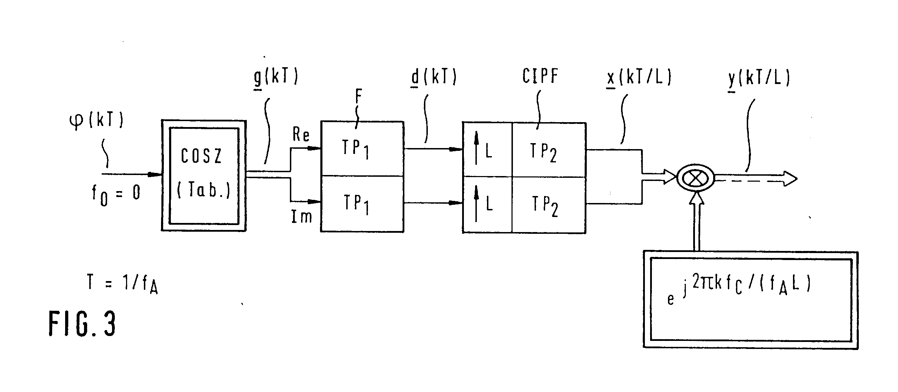

Das erfindungsgemäße Verfahren gemäß vorliegender Zusatzanmeldung geht aus Figur 3 hervor, welche das Blockschaltbild für einen Teil des abgewandelten FM-Modulators wiedergibt. Die eingangsseitige Verarbeitung des modulierenden NF-Signals zur Momentanphase $\varphi$ (kT) des FM-modulierten Signals nach Gleichung (2), ob mit oder ohne Multiplikation mit $2\pi$ ist identisch zu Figur 1. Es ist nur der eine Unterschied zu vermerken, daß $f_0$ identisch $\equiv 0$ angenommen wird. Damit liegt die Schwerpunkts oder Zwischenfrequenz von $\underline{g}$(k) und $\underline{d}$(k) bei $f_0 = 0$, weshalb das Bandbegrenzungsfilter F nunmehr bezüglich $f_0 = 0$ einen symmetrischen Frequenzgang aufweist. Damit sind seine Koeffizienten reell, zwei Teilfilter des üblicherweise aus vier Teilfiltern bestehenden komplexwertigen Filters (siehe Fig. 4) entfallen, was etwa einer Aufwandshalbierung entspricht.

Dasselbe gilt auch für das komplexe Interpolationsfilter CIPF. Beide Filter F und CIPF bestehen damit aus jeweils zwei identischen Tiefpässen TP1 bzw. TP2, die jeweils im Realzweig und im Imaginärteilzweig eingesetzt sind.

Eine Frequenzverschiebung des komplexwertigen Ausgangssignals $\underline{x}$(kT/L), welches bei $f_0 = 0$ zentriert ist, läßt sich durch eine komplexe Multiplikation entsprechend Fig. 4 durchführen. Anstelle der Filterblöcke wird multipliziert mit dem Wert $e^{j2\pi kf_C/(f_A \cdot L)}$ und zwar in vier reellen Multiplikationen entsprechend Gl. (3). Die komplexen Abtastwerte der Trägerschwingung der Frequenz $f_C$ werden entsprechend dem komplexen Oszillator COSZ aus Tabellen ausgelesen oder aktuell berechnet.

Weitere Vereinfachungen zur Aufwandsverminderung lassen sich beim Interpolationsfilter erreichen, wenn anstatt einer einzigen Stufe mit dem Interpolationsfaktor L in einer Kaskade von I-Teilfiltern mit den einzelnen Teilinterpolationsfaktoren $L_i$ interpoliert und gefiltert wird. Dabei wird der Faktor L gemäß

$$L = \prod_{i=1}^{I} L_i \qquad (7)$$

in I ganzzahlige Teilfaktoren zerlegt, wobei die Faktoren $L_i$ zwar nicht zwingend ganzzahlig sein müssen aber sinnvoll so festgelegt werden.

## Patentansprüche

1. Verfahren zur FM-Modulation eines digitalen Trägersignals mit einem digitalen NF-Signal mittels eines rückgekoppelten Phasenakkumulators und eines Trägeroszillators, welcher numerisch gesteuert die Abtastwerte der modulierten FM-Schwingung bzw. des FM-Signals erzeugt, dadurch gekennzeichnet, daß der Trägeroszillator (COSZ) mit einer Abtastrate $f_A = 1/T$ arbeitet, die größer ist als die FM-Bandbreite,
daß ein komplexwertiges FM-Zwischenfrequenz-Signal g(kT) erzeugt wird, wobei die Zwischenfrequenz des nichtmodulierten Trägers $f_0 = 0$ bzw. $f_0 = M \cdot f_A$ ist mit der ganzen Zahl M > 1,
daß anschließend Real- und Imaginärteil des FM-Signals jeweils mittels zweier identischer reellwertiger Tiefpässe (F, TP1) zu $\underline{d}$(kT) bandbegrenzt werden und
daß anschließend Real- und Imaginärteil von $\underline{d}$(kT) jeweils interpoliert und mittels zweier zweiten identischer reellwertiger Tiefpässe (CIPF, TP2) zur Erhöhung der Abtastfrequenz $f_A$ um den Faktor L zu $\underline{x}$(kT/L) gefiltert werden, wobei L>1 ist.

2. Verfahren nach Anspruch 1, dadurch gekennzeichnet, daß das komplexwertige durch die zweiten Tiefpässe (TP2) gefilterte Ausgangssignal $\underline{x}$(kT/L) mit $e^{j2\pi k f_C/(L \cdot f_A)}$ multipliziert wird zu dem komplexwertigen Ausgangssignal $\underline{y}$ (kT/L), entsprechend einer Frequenzverschiebung zu der ausgangsseitig gewünschten Schwerpunktfrequenz $f_C$ des FM-Signals.

3. Verfahren nach Anspruch 1 oder 2, dadurch gekennzeichnet, daß die Bandbegrenzung des FM-Signals auf die UKW-Bandbreite gleich 300 kHz erfolgt.

4. Verfahren nach einem der vorhergehenden Ansprüche, dadurch gekennzeichnet, daß aus dem interpolierten Ausgangssignal $\underline{y}$(kT/L) durch Berechnung des Real- oder Imaginärteils ein reellwertiges FM-Signal y(kT/L) erzeugt wird.

5. Verfahren nach Anspruch 4, dadurch gekennzeichnet, daß das reellwertige FM-Signal Digital- Analog- umgesetzt wird.

6. Verfahren nach Anspruch 5, dadurch gekennzeichnet, daß das analoge FM-Signal mittels eines analogen Glättungsfilters (ABP) geglättet wird.

7. Verfahren nach einem der vorhergehenden Ansprüche, dadurch gekennzeichnet, daß die Abtastrate $f_{A0}$ des modulierenden digitalen NF-Signals v' = v (kPT) das 1/P-fache der Abtastrate $f_A$ des komplexen Oszillators (COSZ) ist, wobei P eine rationale oder eine ganze Zahl ist.

8. Verfahren nach einem der vorhergehenden Ansprüche, dadurch gekennzeichnet, daß zwischen dem rückgekoppelten Phasenakkumulator und dem komplexen Oszillator (COSZ) eine Multiplikation mit $2\pi$ erfolgt.

9. Verfahren nach einem der vorhergehenden Ansprüche, dadurch gekennzeichnet, daß die Abtastwerte der modulierten FM-Schwingung aus einer Tabelle ausgelesen werden.

10. Verfahren nach Anspruch 9, dadurch gekennzeichnet, daß die Tabelle des komplexen Oszillators (COSZ) zwei Teile mit gleichem Inhalt aber mit unterschiedlichen Adressen enthält, die zur Lieferung des Real- und Imaginärteils des komplexwertigen FM-Zwischenfrequenzsignals gleichzeitig angesteuert und ausgelesen werden.

11. Verfahren nach Anspruch 9, dadurch gekennzeichnet, daß die Tabelle des komplexen Oszillators (COSZ) aus einem Sinus- und einem Cosinusteil besteht, die unter der gleichen Adresse jeweils gleichzeitig angesteuert und ausgelesen werden.

12. Verfahren nach Anspruch 9, dadurch gekennzeichnet, daß die Tabelle des komplexen Oszillators (COSZ) nur eine einzige Wertetabelle für Real- und Imaginärteil umfasst, die sequentiell angesteuert und ausgelesen werden.

13. Verfahren nach einem der Ansprüche 1 bis 8, dadurch gekennzeichnet, daß die aktuellen Abtastwerte der komplexen FM-Schwingung jeweils mittels eines speziellen Rechenwerkes berechnet werden.

14. Verfahren nach einem der vorhergehenden Ansprüche, dadurch gekennzeichnet, daß das Interpolationsfilter (CIPF) durch ein Polyphasennetzwerk realisiert ist.

15. Verfahren nach einem der vorhergehenden Ansprüche, dadurch gekennzeichnet, daß die ersten und/oder die zweiten Tiefpässe mit reellwertigen Koeffizienten (TP1, TP2) als nichtrekursive Filter (FIR) realisiert sind.

16. Verfahren nach einem der vorhergehenden Ansprüche, dadurch gekennzeichnet, daß die beiden reellwertigen ersten und zweiten Tiefpässe (TP1 und TP2) sowohl im Realzweig als auch im Imaginärteilzweig zusammengefasst werden.

17. Verfahren nach einem der Ansprüche 1 bis 15, dadurch gekennzeichnet, daß das Interpolationsfilter (CIPF) als eine Kaskade von I Teilfiltern mit den Teilinterpolationsfaktoren $L_i$ realisiert ist, wobei

$$L = \prod_{i=1}^{I} L_i$$

ist.

18. Verfahren nach einem der vorhergehenden Ansprüche, dadurch gekennzeichnet, daß L eine ganze Zahl ist.

## Claims

1. Method for frequency modulation of a digital carrier signal with a digital AF signal by means of a feedback phase accumulator and a carrier oscillator which, numerically controlled, produces the samples of the modulated FM oscillation or of the FM signal, characterized in that the carrier oscillator (COSZ) operates at a sampling rate $f_A = 1/T$ which is greater than the FM bandwidth,
in that a complex FM intermediate-frequency signal g(kT) is produced, the intermediate frequency of the unmodulated carrier being $f_0 = 0$ or $f_0 = M \cdot f_A$ where M is an integer greater than 1, in that, subsequently, the real part and imaginary part of the FM signal are respectively band-limited by means of two identical real low-pass filters (F, TP1) to produce $\underline{d}(kT)$, and in that, subsequently, the real part and imaginary part of $\underline{d}(kT)$ are in each case interpolated and are filtered by means of two second identical real low-pass filters (CIPF, TP2) in order to increase the sampling frequency $f_A$ by the factor L to $\underline{y}(kT/L)$, where L is greater than 1.

2. Method according to Claim 1, characterized in that the complex output signal $\underline{x}(kT/L)$ which has been filtered by the second low-pass filters (TP2) is multiplied by $e^{j2\pi k f_C/(L \cdot f_A)}$ to produce the complex output signal $\underline{y}(kT/L)$, corresponding to a frequency shift to produce the centre frequency $f_C$ of the FM signal desired on the output side.

3. Method according to Claim 1 or 2, characterized in that the band limiting of the FM signal is applied to the VHF bandwidth of 300 kHz.

4. Method according to one of the preceding claims, characterized in that a real FM signal y(kT/L) is produced from the interpolated output signal $\underline{y}(kT/L)$ by calculation of the real part or imaginary part.

**5.** Method according to Claim 4, characterized in that the real FM signal is converted from digital to analogue.

**6.** Method according to Claim 5, characterized in that the analogue FM signal is smoothed by means of an analogue smoothing filter (ABP).

**7.** Method according to one of the preceding claims, characterized in that the sampling rate $f_{A0}$ of the modulating digital AF signal $v' = v(kPT)$ is 1/P-times the sampling rate $f_A$ of the complex oscillator (COSZ), P being a rational number or an integer.

**8.** Method according to one of the preceding claims, characterized in that multiplication by $2\pi$ is carried out between the feedback phase accumulator and the complex oscillator (COSZ).

**9.** Method according to one of the preceding claims, characterized in that the samples of the modulated FM oscillation are read from a table.

**10.** Method according to Claim 9, characterized in that the table for the complex oscillator (COSZ) contains two parts having the same contents but having different addresses, which are actuated and read from simultaneously in order to supply the real part and imaginary part of the complex FM intermediate frequency signal.

**11.** Method according to Claim 9, characterized in that the table for the complex oscillator (COSZ) comprises a sine part and a cosine part, which are respectively actuated and read from simultaneously, at the same address.

**12.** Method according to Claim 9, characterized in that the table for the complex oscillator (COSZ) comprises only a single value table for the real part and imaginary part, which are actuated and read from sequentially.

**13.** Method according to one of Claims 1 to 8, characterized in that the present samples of the complex FM oscillation are in each case calculated by means of a special arithmetic unit.

**14.** Method according to one of the preceding claims, characterized in that the interpolation filter (CIPF) is a polyphase network.

**15.** Method according to one of the preceding claims, characterized in that the first and/or the second low-pass filters are implemented with real coefficients (TP1, TP2) as non-recursive filters (FIR).

**16.** Method according to one of the preceding claims, characterized in that the two real first and second low-pass filters (TP1 and TP2) are combined both in the real path and in the imaginary part path.

**17.** Method according to one of Claims 1 to 15, characterized in that the interpolation filter (CIPF) is designed as a cascade of I partial filters with the partial interpolation factors $L_i$, where

$$L = \prod_{i=1}^{I} L_i.$$

**18.** Method according to one of the preceding claims, characterized in that L is an integer.

**Revendications**

**1.** Procédé de modulation FM d'un signal de porteuse numérique avec un signal BF numérique à l'aide d'un accumulateur de phase à réaction et d'un oscillateur de porteuse, qui génère avec commande numérique, les valeurs de détection de l'oscillation MF modulée ou du signal MF,
caractérisé en ce que

- l'oscillateur de porteuse (COSZ) travaille avec un coefficient de détection $f_A = 1/T$ supérieur à la largeur de bande MF,

- on génère un signal de fréquence intermédiaire MF, complexe g(kT), la fréquence intermédiaire de la porteuse non modulée étant $f_0 = 0$ ou $f_0 = M . f_A$ avec un nombre entier
- $M > 1$,
- puis on limite en bande la partie réelle et la partie imaginaire du signal MF chaque fois à l'aide de deux filtres passe-bas à valeur réelle identique (F, TP1) pour $\underline{d}$(kT) et
- on interpole la partie réelle et la partie imaginaire de $\underline{d}$(kT) et à l'aide de deux filtres passe-bas à valeur réelle identique (CIPF, TP2), on augmente la fréquence de détection $f_A$ du coefficient L pour avoir $\underline{x}$(kT/L) avec L > 1.

2. Procédé selon la revendication 1,
   caractérisé en ce que
   le signal de sortie $\underline{x}$(kT/L), filtré par les seconds filtres passe-bas (TP2) est multiplié par $e^{j2\pi k f_C/(L \cdot f_A)}$ pour donner le signal de sortie complexe $\underline{y}$ (kT/L) correspondant à un décalage de fréquence pour la fréquence du centre de gravité $f_C$ du signal MF, souhaité en sortie.

3. Procédé selon la revendication 1 ou 2,
   caractérisé en ce qu'
   on limite la bande du signal MF à une largeur de bande MF égale à 300 kHz.

4. Procédé selon l'une des revendications précédentes,
   caractérisé en ce qu'
   à partir du signal de sortie interpolé $\underline{y}$(kT/L), on génère un signal MF y(kT/L) de valeur réelle pour le calcul de la partie réelle et de la partie imaginaire.

5. Procédé selon la revendication 4,
   caractérisé en ce que
   le signal MF de valeur réelle subit une conversion numérique/analogique.

6. Procédé selon la revendication 5,
   caractérisé en ce que
   le signal MF, analogique est lissé par un filtre de lissage analogique (ABP) .

7. Procédé selon l'une quelconque des revendications précédentes,
   caractérisé en ce que
   la fréquence de détection $f_{A0}$ du signal numérique BF, modulé à savoir v' = v (kPT) est le multiple selon 1/P du taux de détection $f_A$ de l'oscillateur complexe (COSZ), P étant un nombre rationnel ou un nombre entier.

8. Procédé selon l'une des revendications précédentes,
   caractérisé en ce qu'
   entre l'accumulateur de phase à réaction et l'oscillateur complexe (COSZ), on multiplie par $2\pi$.

9. Procédé selon l'une des revendications précédentes,
   caractérisé en ce qu'
   on extrait des valeurs de détection de l'oscillation MF modulée à partir d'un tableau.

10. Procédé selon la revendication 9,
    caractérisé en ce que
    le tableau de l'oscillateur complexe (COSZ) contient deux parties de même contenu mais avec des adresses différentes qui servent à fournir la partie réelle et la partie imaginaire du signal de fréquence intermédiaire MF complexe, sont commandées simultanément et lues.

11. Procédé selon la revendication 9,
    caractérisé en ce que
    le tableau de l'oscillateur complexe (COSZ) se compose d'une partie sinus et d'une partie cosinus commandées et lues simultanément à la même adresse.

12. Procédé selon la revendication 9,
    caractérisé en ce que
    le tableau de l'oscillateur complexe (COSZ) ne comprend qu'un seul tableau de valeur pour la partie réelle et la partie imaginaire, qui sont commandées et lues séquentiellement.

13. Procédé selon l'une quelconque des revendications 1 à 8,
caractérisé en ce que
la valeur de détection instantanée de l'oscillation MF complexe est calculée à l'aide d'un calculateur particulier.

14. Procédé selon l'une quelconque des revendications précédentes,
caractérisé en ce que
le filtre d'interpolation (CIPF) est constitué par un réseau polyphasé.

15. Procédé selon l'une quelconque des revendications précédentes,
caractérisé en ce que
le premier et/ou second filtre passe-bas à coefficient réel (TP1, TP2) sont constitués par des filtres non récurrents (FIR).

16. Procédé selon l'une quelconque des revendications précédentes,
caractérisé en ce que
les deux premiers et seconds filtres passe-bas (TP1, TP2) à valeur réelle sont réunis dans la branche réelle et dans la branche de la partie imaginaire.

17. Procédé selon l'une quelconque des revendications 1 à 15,
caractérisé en ce que
le filtre par interpolation (CIPF) est réalisé par une cascade de l filtres partiels avec des coefficients d'interpolation partiels $L_i$ avec

$$L = \prod_{i=1}^{I} L_i \ .$$

18. Procédé selon l'une des revendications précédentes,
caractérisé en ce que
L est un nombre entier.

$f_A$     $f_A$     $L f_A$

Signalquelle

$\alpha v(t)$    $\dfrac{\Delta f}{f_A}$   $v(kT)$      $\varphi(kT)$     $\underline{g}(kT)$     $\underline{d}(kT)$   CIPF   $\underline{y}(kT/L)$

$2\pi$

A / D

T

COSZ
(Tab.)

F

L

$\dfrac{f_0}{f_A} = \dfrac{f_C}{f_A} - M$

Re    oder Im

$y(kT/L)$

D / A   $\approx\atop\approx$  → $y(t)$

ABP

komplexer
Oszillator
FM-Modulator!

$\underline{g}(kT) = e^{j\varphi(kT)}$

komplexe
Bandbegrenzung
auf 300kHz

Interpolationsfilter

Analoges
Glättungs-
filter

FIG. 1

FIG.2a

$\underline{G}(e^{j\Omega})$
$\underline{H}_F(e^{j\Omega})$

Grundperiode $(f_A)$

$\underline{H}_F$

$\underline{G}$

FM-Band-breite

$f_0$    $f_A$    $2f_A$    $3f_A$    $f_C = 3f_A + f_0$    $4f_A$    M

FIG.2b

$\underline{D}(e^{j\Omega})$
$\underline{H}_{CTPF}(e^{j\Omega/L})$

$\underline{D}$

$\underline{H}_{CTPF}$

$f_0$    $f_A$    $2f_A$    $3f_A$    $f_C$    $4f_A$

FIG.2c

$\underline{Y}(e^{j\Omega/L})$

$\underline{D}$

$\underline{Y}$

$f_A$    $2f_A$    $3f_A$    $f_C$    $4f_A$

FIG.2d

$Y(e^{j\Omega/L})$
$= Re\{\underline{Y}\}$

$|H_{ABP}|$

Kehrlage bezüglich $f_C$

Regellage

$|H_{ABP}|$

$f_C'$    $f_A$    $2f_A$    $3f_A$    $f_C$    $f_A' = 4f_A$    L

FIG.2e

$|Y(j\omega)|$

symmetrisch zu $2\pi f = \omega = 0$

$|Y|$

$f_A$    $2f_A$    $3f_A$    $f_C$    $4f_A$

11

FIG.3

$T = 1/f_A$

FIG. 4